(19) Europäisches Patentamt
European Patent Office
Office européen des brevets

(11) **EP 2 175 293 A1**

(12) **EUROPÄISCHE PATENTANMELDUNG**

(43) Veröffentlichungstag:
**14.04.2010 Patentblatt 2010/15**

(21) Anmeldenummer: **09015150.7**

(22) Anmeldetag: **07.09.2004**

(51) Int Cl.:
*G02B 5/20* (2006.01)     *G02B 1/10* (2006.01)
*G02B 5/28* (2006.01)     *C23C 14/00* (2006.01)

(84) Benannte Vertragsstaaten:
**AT BE BG CH CY CZ DE DK EE ES FI FR GB GR HU IE IT LI LU MC NL PL PT RO SE SI SK TR**

(30) Priorität: **08.09.2003 DE 10341681**

(62) Dokumentnummer(n) der früheren Anmeldung(en) nach Art. 76 EPÜ:
**04786722.1 / 1 664 861**

(71) Anmelder: **Justus-Liebig-Universität Gießen**
**35390 Giessen (DE)**

(72) Erfinder:
• **Hofmann, Detlev Dr.**
  **35625 Hüttenberg (DE)**

• **Farangis, Baker Dr.**
  **35390 Giessen (DE)**

(74) Vertreter: **Buchhold, Jürgen**
**Patentanwälte**
**Olbricht Buchhold Keulertz & Partner**
**Am Weinberg 15**
**35096 Weimar (Lahn) (DE)**

Bemerkungen:
Diese Anmeldung ist am 07.12.2009 als Teilanmeldung zu der unter INID-Code 62 erwähnten Anmeldung eingereicht worden.

(54) **Optische Funktionsschichten, insbesondere Zinkoxid-Sulfid-Schichten mit variabler dielektrischer Response**

(57) Die Erfindung betrifft eine neuartige optische Funktionsschicht und deren Herstellverfahren, wobei die Funktionsschichicht für damit beschichtete Substanzen einen Schutz vor UV-Strahlung ermöglicht, während elektromagnetische Strahlung größerer wellenlängen transmittiert wird. Die erfindungsgemäße Funktions-schicht und das erfindungsgemäße Herstellverfahren weist als vorteile gegenüber dem Stand der Technik eine sehr genaue Einstellbarkeit der relativ scharfen Abaorptionskante im UV-Bereich auf.

Fig. 1

EP 2 175 293 A1

Fig. 4

**Beschreibung**

Die vorliegende Erfindung betrifft das Gebiet der funktionalen Schichten, die auf die zu schützenden Materialien oder Substrate wie z.B. mineralisches Glas, Plexiglas oder Folien wie Kunststofffolien aufgebracht werden können und die Transmission des einfallenden Lichtes ab einer bestimmten, meist bei der Produktion eingestellten Wellenlänge verhindern, um Schädigungen durch Licht zu vermeiden.

Die vorliegende Erfindung betrifft insbesondere eine funktionale Schicht aus $ZnO_xS_{1-x}$, deren Absorption oder Transmission in einem vorher einstellbaren Wellenlängenbereich eine abrupte Änderung erfährt, sowie eine derartige Schicht, die elektrisch leitfähig ist. Des weiteren betrifft die Erfindung ein Verfahren zur Herstellung derartiger Schichten.

Durch Bestrahlung mit Licht können Materialien verändert oder geschädigt werden. Beispiele hierfür sind die Schädigungen von biologischem Gewebe durch Verbrennung (Sonnenbrand), von funktionalen Molekülstrukturen in organischen elektro-optischen Bauelementen wie organischen lichtemittierenden Dioden (OLED), oder organischen Solarzellen, von Festkörpern oder von Pigmentfarben, wie sie in Bildern verwendet werden oder von Fensterbeschichtungen mit elektrisch schaltbarer Transmission (elektrochrome Fenster).

Diese Aufgabe löst man im Stand der Technik durch Filter, die in einem langwelligen Bereich das Licht möglichst ungestört transmittieren und ab einer bestimmten Wellenlänge $\lambda_0$ möglichst scharf und vollständig abschneiden. Diese Wellenlänge hängt von dem Schädigungseffekt des Lichtes auf das zu schützende Material ab. Derartige Filter bestehen in der Regel aus eingefärbten Gläsern. Für jede Filterfunktion muss hierbei eine gesonderte Schmelze mit den entsprechenden Zusätzen angesetzt werden. Diese Filter weisen jedoch in der Regel einen breiten Übergangsbereich bei $\lambda_0$ auf.

Verbesserungen erzielt man durch die Kombination mit Interferenzfiltern. Durch den Abbau der Ozonschicht im Bereich der Polarregionen ist jedoch der Bedarf entstanden, auch in Gebäuden einen entsprechenden Schutz zu gewährleisten. Da Floatglas hierfür nur eingeschränkt geeignet ist, werden Materialien gesucht, die einerseits das sichtbare Sonnenlicht möglichst uneingeschränkt transmittieren und andererseits das UV-Licht nahezu vollkommen abschneiden.

Für transparente leitfähige Funktionsschichten setzt man transparent conductive oxides (TCO) wie $In_2O_3$:Sn (ITO), ZnO:Al, $SnO_2$:F ein, die in der Regel in pyrolytischen oder Sputterprozessen hergestellt werden. Sie zeigen allerdings bis in den ultravioletten Spektralbereich hohe Transparenz, darüber hinaus kann die Absorptionskante nicht variiert werden.

Es ist bekannt, dass Legierungen oder Gemische dielektrischer Materialien Eigenschaften besitzen können, die zwischen oder auch außerhalb (bowing) derer der Ursprungssubstanzen liegen. Dies wurde für das vorteilhafte ZnO sowohl durch anionische als auch durch kationische Substitution getestet.

Eine Schwefeldotierung von ZnO-Schichten, die mit alternierender, gepulster Laserdeposition (PLD) von zwei keramischen Targets (ZnO/ZnS) auf Saphir hergestellt wurden, ergibt eine erhöhte UV-Absorption bei einem maximalen Anteil von 14 % Schwefel in ZnO (Y.-Z. Yoo et al., Appl. Phys. Lett. 81, 3798 (2002)). Dies ist jedoch mit dem Nachteil einer starken Verbreiterung der Absorptionskante verbunden, da sich bei höherer Schwefel-Konzentration Fremdphasen ausbilden. Verschiebungen der Absorptionskante von ZnO in Richtung UV können durch Legierung mit MgO (3.3 bis 4.0 eV) oder in Richtung sichtbarer Spektralbereich mit CdO (3.3 bis 3.0 eV) realisiert werden (T. Makino et al., Appl. Phys. Lett. 78, 1237 (2001)).

Bisher ist jedoch keine ternäre Verbindung synthetisiert worden, die den Bereich 3.7 eV bis 2.5 eV abdecken könnte.

In der Patentschrift US 20030042851 A1 (March 6, 2003), Iwata et al., wird eine quaternäre ZnOSSe-Schicht auf SiliziumSubstraten abgeschieden, die als lichtemittierendes Bauteil Einsatz finden soll. Dazu wird mit theoretischen Berechnungen die Bandlückenenergien für ZnSSe, ZnOS und ZnOSe abgeschätzt. Danach variiert die Bandlückenenergie in Abhängigkeit von der Zusammensetzung der quarternären Verbindung vom UV über den sichtbaren bis in den infraroten Bereich. Experimentelle Ergebnisse aus diesem Patent liegen nur für ZnOSe (nicht für ZnSSe, nicht für ZnOS vor) mit einem maximalen Se-Anteil von 15 % vor, das ebenfalls mittels PLD hergestellt wurde. Insbesondere wurde kein Verfahren zur Herstellung von ZnOS-Mischsystemen offenbart. Gegenwärtig sind auch keine anderen Publikationen bekannt, die eine realistische Darstellung oder Herstellung eines ZnOS Mischsystems präsentieren.

Zur Erzielung einer abrupten Absorptionskante, wurden bisher dielektrische Schichten eingesetzt, die durch die Materialeigenschaften definiert ist. Damit kann aber die Zielsetzung maximaler Transmission oberhalb einer gewünschten Wellenlänge bei minimaler Transmission unterhalb dieser Wellenlänge nicht erreicht werden.

Zur Umgehung der Schwierigkeiten (Verbreiterung der Absorptionskante) beim PLD-Verfahren zur Herstellung von $ZnO_xS_{(1-x)}$ wurde nun auf industrielle Methoden zur Herstellung von ZnO zurückgegriffen. Hierzu wurde reaktives Sputtern von metallischen Zn-Targets unter Sauerstoff- und/oder Schwefelwasserstoff-Zugabe eingesetzt. Auch hier konnten keine Legierungsschichten von ZnOS abgeschieden werden; Deposition fand nur in den Bereichen mit überwiegendem O- oder S-Gehalt (um 90%) statt, während die gewünschte Co-Deposition nicht festgestellt wurde.

Eine probate Methode zur Umgehung dieser Schwierigkeiten stellt die Verwendung keramischer ZnO-Targets dar. Jedoch konnte auch hier in einem weiten Leistungs-, Temperatur- und H2S-Fluss-Bereich kein weiterer Erfolg, d.h.

keine Herstellmöglichkeit einer Legierung, festgestellt werden.

**[Aufgabe der Erfindung]**

Aufgabe der Erfindung ist es daher eine optische Funktionsschicht vorzusehen, welche eine im Bereich des UV (z.B. im Bereich von ca. 2.6 eV bis 3.8 eV) bei einer Wellenlänge $\lambda_0$ einstellbare, scharfe Absorptionskante und eine maximale Transmission oberhalb der gewünschten Wellenlänge bei minimaler Transmission unterhalb dieser Wellenlänge aufweist.

Weiterhin ist es Aufgabe der vorliegenden Erfindung ein Verfahren zur Herstellung einer solchen Funktionsschicht vorzusehen. Eine dritte Aufgabe der vorliegenden Erfindung ist es ein optisches Funktionselement vorzusehen, welches die erfindungsgemäße Funktionsschicht umfasst und schützt.

Die erste Aufgabe wird erfindungsgemäß gelöst durch eine optische Funktionsschicht, welche dadurch gekennzeichnet ist, dass sie aus $ZnO_xS_{(1-x)}$ in kristalliner Form besteht.

Überraschenderweise wurde festgestellt, dass sich das Mischsystem ZnOS komplett mischbar als kristalline Dünnschicht synthetisieren lässt und bei der Herstellung die Anteile von O und S in ganzen Bereich (von x=0 bis x=1) einstellen lassen, wobei die daraus resultierende optische Funktionsschicht eine scharfe Absorptionskante mit sehr hoher Transmission bei höheren und sehr geringer Transmission bei niedrigeren Wellenlängen -im Vergleich zur Absorptionskante- aufweist.

Die Bandlückenenergie Eg (x) eines ternären Verbindungshalbleiters wie $ZnO_xS_{(1-x)}$ variiert in der Regel nichtlinear zwischen den binären Endpunkten Eg (ZnO) und Eg (ZnS), ausgedrückt über den "bowing" Parameter b, der den Unterschied in den Elektronegativitäten von Schwefel und Sauerstoff widerspiegelt:

$$E_g \; (x) \; = \; x \; E_g \; (ZnO) \; + \; (1-x) \; E_g \; (ZnS) \; - \; b \; x \; (1-x) \quad (*)$$

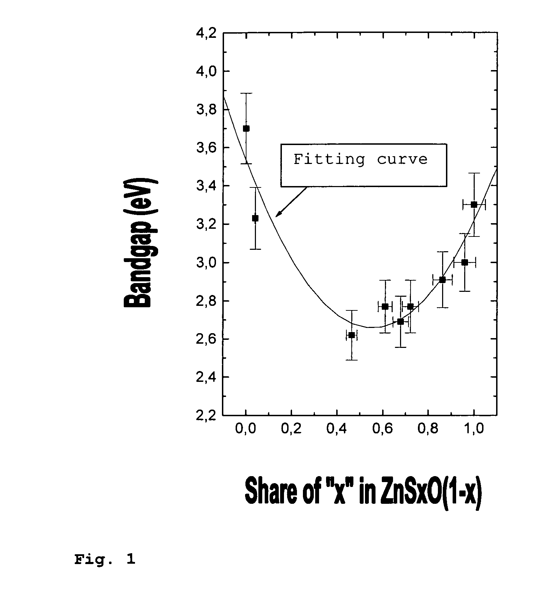

Fig. 1 zeigt dazu die gemessene Verschiebung der Bandlücke legierter $ZnO_xS_{(1-x)}$ - Proben als Funktion des Sauerstoffanteils im Bereich von 0 bis 1. Die eingezeichnete Kurve ist eine Anpassung der Messwerte an die Funktion.

Überraschenderweise ist der experimentell gefundene bowing-Parameter von 2.5 eV viel kleiner als der im Patent US 20030042851 A1 (March 6, 2003), Iwata et al. theoretisch vorhergesagte von 12 eV. Damit verschiebt sich die Bandlücke bis ca. 2.6 eV (je nach Messfehler auch bis zu 2.4 eV), d.h. in den blauen Spektralbereich im Unterschied zu der vorausgesagten Verschiebung in den IR-Bereich.

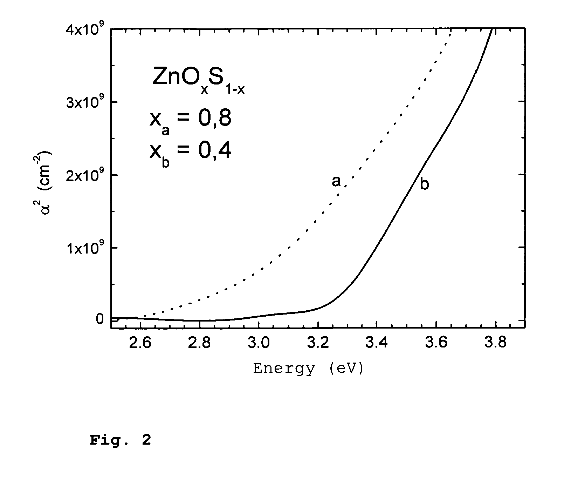

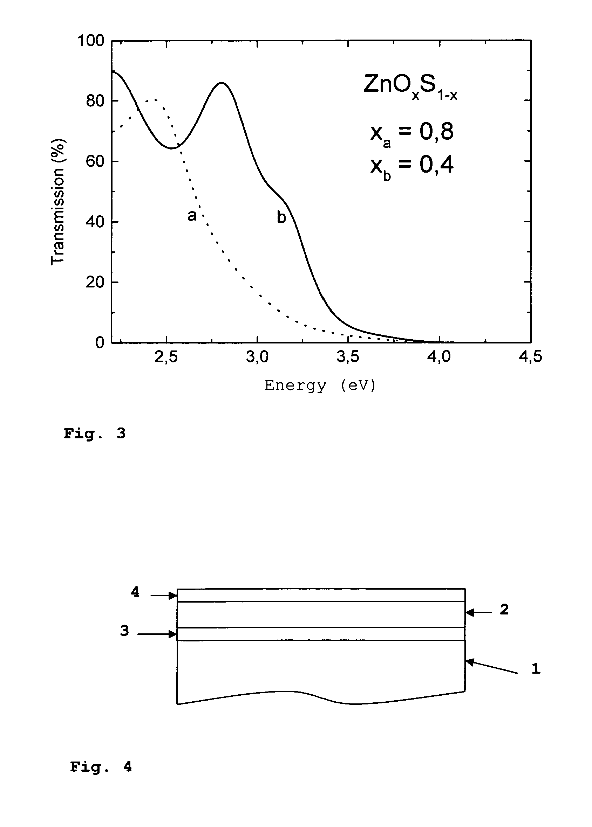

Fig. 2 zeigt als Beispiel den Absorptionskoeffizienten einer ZnOS Schicht mit einem Sauerstoffanteil x=0.4 und x=0.8 auf Floatglas als Substrat. Die Absorptionskante ist steil mit einer exzitonischen Überhöhung und besitzt einen ausgezeichneten Hub (Differenz der Transmission oberhalb und unterhalb der Bandlücke (siehe Fig. 3)). Erfindungsgemäß lässt sich die Absorptionskante im gewünschten Wellenlängen- oder Energiebereich bei großem Hub kontrolliert einstellen, z.B. bei 380 nm, 390 nm, 400 nm. Daraus ergibt sich, dass gewisse Bereiche des Lichtspektrums abgeschnitten werden, z.B. der UV-A-Bereich.

Zudem betrifft die Erfindung ein Verfahren zur Herstellung der beschriebenen Schicht. Diese zweite Aufgabe wird gelöst durch das Verfahren gemäß Anspruch 5.

Die dritte Aufgabe der Erfindung betrifft die Vorsehung eines optischen Funktionselementes. Diese letzte Aufgabe wird gelöst durch das Funktionselement gemäß Anspruch 13.

**[Beispiele]**

Die Figuren 1, 2 und 3 zeigen Messwerte zu $ZnO_xS_{(1-x)}$ mit x aus dem Bereich x nahe 0 bis x = 1 (ZnO).

Die optische Funktionsschicht kann auf einer Substratschicht aus gängigem transparentem Material wie z.B. Glas oder Plexiglas oder nicht transparentem Material aufgebracht werden. Die Funktionsschicht ist kristallin und stellt ein Übergangssystem zwischen ZnO (Bandabstand 3,4 eV) und ZnS (Bandabstand 3,7 eV) dar. Je nach eingestelltem O:S-Verhältnis liegt die Bandkante im Zwischenbereich zwischen ca. 2,5 und 3,7 eV (mit Messfehlern ggf. zwischen 2.5 - 3.9 eV). Damit kann eine Funktionsschicht mit dem gewünschten Bandabstand konfektioniert werden.

Zur Herstellung wird das Substrat mit einem der bekannten Dünnschicht-Depositionsverfahren, z.B. mit der Sputtertechnik, der chemischen Abscheidung aus Gasphasen (CVD, MOCVD), dem Solgelverfahren, durch Aufdampfen, durch Porolyse mit der erfindungsgemäßen Schicht beschichtet.

Eine Abwandlung des Verfahrens und damit ein vorteilhaftes Ausführungsbeispiel zum erfindungsgemäßen Verfahren ergibt sich, wenn zunächst auf das Substrat eine Nukleationsschicht aufgebracht wird, auf welche die Funktionsschicht aufgebracht wird. Als Nukleationsschicht eignen sich besonders solche, die eine ähnliche Struktur und Gitterkonstante, inbesondere bei der Depositionstemperatur der Funktionsschicht, aufweisen.

Auf diese Weise kann das Wachstum der $ZnO_xS_{(1-x)}$-Schicht verbessert und die erforderliche Substrattemperatur gesenkt werden. Dies ist vorteilhaft einerseits im Hinblick auf die Prozesskosten, da ein zeit- und energieaufwendiges Vorheizen des Substrates vermieden werden kann; andererseits können so schädigende Effekte auf das Substrat ausgeschlossen werden, die insbesondere bei organischen Materialen von Bedeutung sind.

Weitere Einzelheiten und vorteilhafte Weiterbildungen der Erfindung ergeben sich aus den im folgenden beschriebenen und in den Zeichnungen dargestellten Ausführungsbeispielen, sowie aus den Unteransprüchen. Es zeigt:

Fig. 1: die Verschiebung der Bandlücke legierter $ZnO_xS_{(1-x)}$ Schichten (in eV) als Funktion des Sauerstoffanteils x im Bereich von 0 < x < 1

Fig. 2: das Quadrat des Absorptionskoeffizienten ($\alpha_2$ in cm$^2$) zweier erfindungsgemäßer Funktionsschichten auf Floatglas als Substrat mit einem Sauerstoffanteil von $x_a$=80% und $x_b$=40%, als Funktion der Energie in eV.

Fig. 3: die Transmission (in %) der beiden Funktionsschichten aus Fig. 2 ($x_a$ = 80% und $x_b$ = 40%) mit Floatglas als Substrat im Bereich der Absorptionskante, in Abhängigkeit von der Energie (eV).

Fig. 4: den Aufbau eines Schichtsystems als optisches Funktionselement auf einem Substrat umfassend -in Richtung vom Substrat nach oben- eine Nukleationsschicht zur Verbesserung der Funktionsschicht-Abscheidung, die Funktionssicht als solche und darüber eine Schutzschicht.

Fig. 1 zeigt die Bandlücke in Abhängigkeit vom Sauerstoffanteil x von 9 untersuchten $ZnO_xS_{(1-x)}$ Funktionsschichten. Deutlich zu erkennen ist, dass die Bandlücke im Bereich von ca. 3.9 eV bis runter zu ca. 2.4 eV einstellbar ist, wenn der Anteil des Sauerstoffgehaltes im Bereich zwischen x=0 und x=1 variiert wird. Prinzipiell ist natürlich auch der Schwefelgehalt variierbar, wenn statt dem ZnS ein ZnO-Target verwendet wird und der Zustrom an Schwefel eingestellt wird.

Fig. 2 zeigt die deutliche Verschiebbarkeit der Bandlücke durch Wahl des Sauerstoffanteils x des in der Funktionsschicht. Gleiches gilt bei Variation des Schwefelgehaltes (siehe oben).

Fig. 3a zeigt die deutliche Abnahme der Transmission von ca. 80% auf nahe 0% innerhalb eines Bereiches der Bandenergie von ca. 0.75 eV.

Fig. 4 zeigt ein optisches Funktionselement, bestehend aus einem Schichtsystem, aufweisend eine erfindungsgemäße Funktionsschicht oberhalb einer auf einem Substrat angebrachten Nukleationsschicht. Die Nukleationsschicht sorgt dabei für ein verbessertes Wachstum (bei tieferen Depositionstemperaturen).

Zur Vermeidung der Beeinträchtigung der Wirkung der Funktionsschicht durch mechanische, oder chemische Beschädigung oder Verschmutzung weist das Schichtsystem noch eine Schutzschicht oberhalb der Funktionsschicht auf. Als Schutzschichten kommen in Frage z.B.: $SiO_2$, SiN, SiON, $Al_2O_3$ und weiter optische durchlässige und ausreichend harte Schichte.

Natürlich kann es für manche Anwendungen auch sinnvoll sein, verschiedene anderer Schutzschichten oberhalb der ersten oder unterhalb des Substrates zusätzlich anzubringen.

Eine besonders vorteilhafte Ausgestaltung des optischen Funktionselementes besteht darin oberhalb der optischen Funktionsschicht oder/und unterhalb des Substrates eine Antioxidationsschicht (5) anzubringen.

Im folgenden wird eine Funktionsschicht und deren Herstellung exemplarisch vorgestellt. Zur Herstellung wurde als Target ZnS gewählt, und über den Sauerstoffzustrom der Parameter x des Anteils von Sauerstoff in der sich ergebenden Schicht und damit die Bandlücke eingestellt.

| Probe | ZnOS - Nr. 077 | |
|---|---|---|
| Substrat: | Saphir, (alternativ auch Suprasil oder Float-glas) | |
| Druck in Kammer: | $4,0 \times 10^{-3}$ Pa | |
| Target: | ZnS | |
| Schicht: | $ZnO_xS_{1-x}$ | |
| Gasfluss Ar: | 4,2 sccm | |
| Gasfluss $O_2$: | 0,9 sccm | |
| | | |
| | Vorsputtern (Reinigung) | Sputtern (Schichtdeposi- |
| Druck | 2,1 Pa | 2,0 Pa |

(fortgesetzt)

| | Vorsputtern (Reinigung) | Sputtern (Schichtdeposi- |
|---|---|---|
| Sputterleistung | 300 W | 300 W |
| Spannung Target-ubstrat durch Selbstaufladung | 3,3 kV | 3,15 kV |
| Substrat-Temperatur | 300 °C | 300 °C auf 360 °C ansteigend |
| Sputterzeit | 10 min | 30 min |
| | | |
| **Zusammensetzung der Schicht in Atom%** | | |
| Zn | O | S |
| 54 | 33 | 12 |

Mit diesem Ergebnis ist Fig. 1 zu entnehmen, dass die Funktionsschicht eine Bandlücke im Bereich von ca. 2.7 bis 2.9 eV aufweist. Damit ergibt sich -aufgrund des ähnlichen Sauerstoffanteils- ein Verlauf des Absorptionskoeffizienten und des Transmissionskoeffizienten (s. Fig. 2,3) ähnlich zu denen für $x_b$=0.4.

Die erfindungsgemäße Funktionsschicht kann generell überall dort verwendet werden, wo eine Abscheidung auf einem Substrat möglich ist und das Substrat selber oder darunter liegende Material vor UV-Einstrahlung zu schützen sind. Damit gehören zu den Anwendungsfeldern -nicht abschliessend- folgende Bereiche: Beschichtungen für a) Architekturglas, b) UV-Schutzgläser für PKW, Sonnenbrillen, Sonnenbänke, Lebensmittelverpackungen, etc., c) Textilien für Menschen oder generell Textilien.

Ausserdem ist die optische Funktionsschicht auch -aufgrund der Reflexionsminderung- als Ersatz für dielektrische Schichten in opto-elektronischen Anwendungen verwendbar.

Dem Fachmann ist unmittelbar einsichtig, dass die Funktionsschicht auch auf flexible Substrate übertragbar ist.

Ferner ist dem Fachmann einsichtig, dass die Funktionsschicht auch als Antireflexionsschicht einsetzbar ist.

**[Bezugszeichenliste]**

1    Substrat
2    Funktionsschicht
3    Nukleationsschicht
4    Schutzschicht
5    Antioxidationsschicht

**Patentansprüche**

1. Optische Funktionsschicht (2), die ein ternärer Verbindungshalbleiter aus $ZnO_xS_{(1-x)}$ in kristalliner Form ist und auf einem Substrat abgeschieden ist, **dadurch gekennzeichnet, dass** sie einen bowing-Parameter b von 2,5 eV aufweist, dass das Substrat ausgewählt ist aus Floatglas, Plexiglas oder einem nicht-transparenten Material, dass die Absorptionskante auf eine Wellenlänge $\lambda_0$ eingestellt ist, wobei die Transmission im Bereich der Absorptionskante von 80% auf nahe 0% innerhalb eines Bereiches der Bandenergie von 0,75 eV abnimmt.

2. Optische Funktionsschicht entsprechend Anspruch 1, **dadurch gekennzeichnet, dass** die Absorptionskante im Zwischenbereich zwischen 2,5 und 3,7 eV liegt.

3. Optische Funktionsschicht nach einem der Ansprüche 1 oder 2, **dadurch gekennzeichnet, dass** die Absorptionskante eine Wellenlänge von 380, 390 oder 400 nm aufweist.

4. Funktionsschicht nach Anspruch 1 bis 3, **dadurch gekennzeichnet, dass** sie eine Kristall-Struktur nach dem Wurtzit-Typ aufweist.

5. Funktionsschicht nach einem der Ansprüche 1 bis 4, **dadurch gekennzeichnet, dass** sie eine Bandlücke im Bereich von 2,7 bis 2,9 eV aufweist.

**6.** Optisches Funktionselement, **dadurch gekennzeichnet, dass** es eine Funktionsschicht (2) nach einem der Ansprüche 1 bis 5 sowie ein Substrat (1) und mindestens eine Schutzschicht (4) und/oder mindestens eine Antioxidationsschicht (5) aufweist.

**7.** Funktionselement nach Anspruch 6, **dadurch gekennzeichnet, dass** auf dem Substrat (1) eine Nukleationsschicht (3) aufgebracht ist.

**8.** Verfahren zur Herstellung einer optischen Funktionsschicht (2) nach einem der Ansprüche 1 bis 5 mittels Sputter-Technik enthaltend die Schritte:

a) Bereitstellung eines Substrates (1)
b) Bereitstellung von Zn in Form von ZnO oder/und ZnS als keramische Targets und/oder Zn als metallisches Target;
c) Zuführung von Sauerstoff, in Form von O, $O_2$, $H_2O$, Oder/und Zuführung von Schwefel, z.B. in Form von $H_2S$ und
d) Abscheidung der erzeugten $ZnO_xS_{(1-x)}$ - Legierung auf dem Substrat (1) entsprechend der gewünschten Schichtdicke

**dadurch gekennzeichnet, dass** das Substrat ausgewählt ist aus Glas, Plexiglas, einer Polymerfolie oder einem nicht transparenten Material.

**9.** Verfahren nach Anspruch 8, **dadurch gekennzeichnet, dass** eine Substrat-Temperatur von 300 °C bis 360 °C gewählt wird.

**10.** Verfahren nach einem der Ansprüche 8 oder 9, **dadurch gekennzeichnet, dass** die Einstellung des Anteils von Sauerstoff in der sich ergebenden Schicht und damit der Bandlücke über den Sauerstoffzustrom erfolgt.

**11.** Verfahren nach einem der Ansprüche 8 bis 10, **dadurch gekennzeichnet, dass** als keramisches Target ZnS gewählt wird.

**12.** Verfahren nach einem der Ansprüche 8 bis 11, **dadurch gekennzeichnet, dass** vor dem Schritt der Abscheidung der Funktionsschicht (2) eine Nukleationsschicht (3) auf das Substrat aufgebracht wird.

**13.** Verfahren nach einem der Ansprüche 8 bis 12, **dadurch gekennzeichnet, dass** ein Gasfluss von 4.2 sccm für Ar, bei einem Arbeitsdruck von ca. 2 Pa sowie eine Sputterleistung von ca. 300 W bei einer Spannung Target - Substrat von ca. 3-3.5 kV sowie ein Druck in der Kammer von 4 mPa gewählt wird.

**14.** Optische Funktionsschicht, **dadurch gekennzeichnet, dass** es eine optische Funktionsschicht gemäß einem der Ansprüche 1 bis 5 ist, die nach einem Verfahren gemäß einem der Ansprüche 8 bis 13 hergestellt ist.

**15.** Verwendung der Funktionsschicht (2) nach einem der Ansprüche 1 bis 5 als Schutz vor UV-Strahlung, insbesondere für Flugzeuge (Sichtfenster oder Teile der Außenhaut), für Gläser insbesondere für Architektur- oder Brillengläser, für Kraftfahrzeuge (Gläser oder Kunststoffteile), für Kunststoffe, insbesondere Lebensmittelverpackungen oder für Textilien oder zur Ersetzung von dielektrischen Schichten in opto-elektronischen Anwendungen.

Fig. 1

Fig. 2

Fig. 3

Fig. 4

Europäisches Patentamt

European Patent Office

Office européen des brevets

# EUROPÄISCHER RECHERCHENBERICHT

Nummer der Anmeldung

EP 09 01 5150

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X,D | YOO Y-Z ET AL: "S doping in ZnO film by supplying ZnS species with pulsed-laser-deposition method" APPLIED PHYSICS LETTERS, AMERICAN INSTITUTE OF PHYSICS. NEW YORK, US, Bd. 81, Nr. 20, 11. November 2002 (2002-11-11), Seiten 3798-3800, XP012032518 ISSN: 0003-6951 * Seite 3798, Spalte 2, Absatz 2; Abbildung 2 * * Seite 3799, Spalte 1, Absatz 3 - Spalte 2, Absatz 1; Abbildung 2 * ----- | 1-15 | INV. G02B5/20 G02B1/10 G02B5/28 C23C14/00 |
| X | EP 1 178 543 A (NATIONAL INSTITUTE OF ADVANCED INDUSTRIAL SCIENCE AND TECHNOLOGY; ROHM) 6. Februar 2002 (2002-02-06) * Absatz [0008] - Absatz [0011] * * Absatz [0023]; Abbildung 6 * ----- | 1 | |
| X | PLATZER-BJORKMAN C ET AL: "Atomic layer deposition of Zn(O,S) buffer layers for high efficiency Cu(In,Ga)Se2 solar cells" PROCEEDINGS OF 3RD WORLD CONFERENCE ON PHOTOVOLTAIC ENERGY CONVERSION (IEEE CAT. NO.03CH37497) ARISUMI PRINTING INC JAPAN, JAPAN, Bd. 1, 18. Mai 2003 (2003-05-18), Seiten 461-464 VOL.1, XP002317884 ISBN: 4-9901816-0-3 * Abschnitt 1 und 2 * ----- -/-- | 1 | |

RECHERCHIERTE SACHGEBIETE (IPC)

G02B
C23C

Der vorliegende Recherchenbericht wurde für alle Patentansprüche erstellt

| Recherchenort | Abschlußdatum der Recherche | Prüfer |
|---|---|---|
| München | 25. Februar 2010 | Hambach, Dirk |

EPO FORM 1503 03.82 (P04C03)

Europäisches
Patentamt

European
Patent Office

Office européen
des brevets

**EUROPÄISCHER RECHERCHENBERICHT**

**Nummer der Anmeldung**

EP 09 01 5150

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | YOUSFI E B ET AL: "Cadmium-free buffer layers deposited by atomic later epitaxy for copper indium diselenide solar cells" THIN SOLID FILMS, ELSEVIER-SEQUOIA S.A. LAUSANNE, CH, Bd. 361-362, Nr. 1, Februar 2000 (2000-02), Seiten 183-186, XP004187467 ISSN: 0040-6090 * Abschnitt 2 und 3.3,Tabelle 2 * ----- | 1 | |
| X | SANDERS B W ET AL: "ZINC OXYSULFIDE THIN FILMS GROWN BY ATOMIC LAYER DEPOSITION" CHEMISTRY OF MATERIALS, AMERICAN CHEMICAL SOCIETY, WASHINGTON, US, Bd. 4, Nr. 5, 1. September 1992 (1992-09-01), Seiten 1005-1011, XP000306451 ISSN: 0897-4756 * Seite 1005, Spalte 1 - Spalte 2; Tabelle I * * Seite 1009, Spalte 2; Abbildung 13 * ----- | 1-15 | |
| X | ORENT T: "Stress modification in sputtered zinc sulfide and zinc oxysulfide thin films" JOURNAL OF VACUUM SCIENCE & TECHNOLOGY A (VACUUM, SURFACES, AND FILMS) USA, Bd. 9, Nr. 4, Oktober 1991 (1991-10), Seiten 2447-2452, XP002317885 ISSN: 0734-2101 * Seite 2447, Absatz II * * Seite 2448; Tabelle I * * Seite 2449, Spalte 1, Absatz 4 * ----- -/-- | 1 | RECHERCHIERTE SACHGEBIETE (IPC) |

Der vorliegende Recherchenbericht wurde für alle Patentansprüche erstellt

| Recherchenort | Abschlußdatum der Recherche | Prüfer |
|---|---|---|
| München | 25. Februar 2010 | Hambach, Dirk |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes
    Dokument

EPO FORM 1503 03.82 (P04C03)

Europäisches Patentamt
European Patent Office
Office européen des brevets

# EUROPÄISCHER RECHERCHENBERICHT

**Nummer der Anmeldung**

EP 09 01 5150

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | LOKHANDE C D ET AL: "Preparation of Znx(O,S)y thin films using modified chemical bath deposition method" APPLIED SURFACE SCIENCE ELSEVIER NETHERLANDS, Bd. 187, Nr. 1-2, 14. Februar 2002 (2002-02-14), Seiten 101-107, XP002317886 ISSN: 0169-4332 * Seite 101, Spalte 1, Absatz 1 * * Seite 102, Spalte 1, Absatz 3 - Spalte 2, Absatz 1 * ----- | 1 | |

**RECHERCHIERTE SACHGEBIETE (IPC)**

Der vorliegende Recherchenbericht wurde für alle Patentansprüche erstellt

| Recherchenort | Abschlußdatum der Recherche | Prüfer |
|---|---|---|
| München | 25. Februar 2010 | Hambach, Dirk |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

...................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**  EP 09 01 5150

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

25-02-2010

| Im Recherchenbericht angeführtes Patentdokument | Datum der Veröffentlichung | Mitglied(er) der Patentfamilie | Datum der Veröffentlichung |
|---|---|---|---|
| EP 1178543 A | 06-02-2002 | JP 2002016285 A<br>US 2002014631 A1 | 18-01-2002<br>07-02-2002 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20030042851 A1, Iwata

**In der Beschreibung aufgeführte Nicht-Patentliteratur**

- **Y.-Z. Yoo et al.** *Appl. Phys. Lett.,* 2002, vol. 81, 3798

- **T. Makino et al.** *Appl. Phys. Lett.,* 2001, vol. 78, 1237